# EUROPEAN PATENT SPECIFICATION

(11) **EP 0 294 090 B1**
(45) Date of publication and mention of the grant of the patent: **08.12.1993**
(21) Application number: 88304734.2
(22) Date of filing: 25.05.1988
(51) Int. Cl.: H03H 9/05

(54) **Longitudinal resonator**
Längsresonator
Résonateur longitudinal

(30) Priority: 02.06.1987 JP 138382/87
(43) Date of publication of application: 07.12.1988
(73) Proprietor: SEIKO ELECTRONIC COMPONENTS LTD., Sendai-shi Miyagi (JP)
(72) Inventor: Kawashima, Hirofumi, Sendai-shi Miyagi-ken (JP)
(74) Representative: Miller, Joseph

(56) References cited:
- PATENT ABSTRACTS OF JAPAN, vol. 9, no. 208 (E-338)[1931], 24th August 1985; & JP-A-60 70 810 (MATSUSHIMA KOGYO K.K.) 22-04-1985
- PATENT ABSTRACTS OF JAPAN, vol. 4, no. 87 (E-16)[569], 21st June 1980; & JP-A-55 52 621 (MATSUSHITA KOGYO K.K.) 17-04-1980

## Description

The present invention concerns a longitudinal resonator and, although the invention is not so restricted, it more particularly concerns a longitudinal quartz crystal resonator having an intermediate frequency of 1 MHz or thereabouts.

In a known longitudinal quartz crystal resonator having a vibrational portion and a supporting portion which are integrally formed by an etching method, a frame of the supporting portion has a uniform width in the same direction and is mounted at an end portion thereof. Hence, the energy of the vibrational portion is transmitted to the mounting portion of the frame, which causes vibrational leakage. For this reason, a longitudinal quartz crystal resonator having a low series resistance R₁ is not obtained.

In order to overcome this defect it has been necessary to increase the amplitude of the respective IC, but this involves increased consumption of electric current. In the worst case, because a large amount of vibrational leakage (losses caused by vibration) occurs when the resonator is used in communication equipment and in consumer products, such as timepieces, it is even possible for the vibration of the resonator to be stopped.

In JP-A-60-70810 there is disclosed a piezo-electric vibrator produced by photo-etching whose vibrational portion is held by a flexural portion which is itself directly connected to the bottom side only of a frame, this construction being designed to prevent leaked vibration.

According, therefore, to the present invention, there is provided a one-piece longitudinal piezo-electric resonator comprising a vibrational portion and a flexural portion which supports the vibrational portion by way of bridge means and which is directly connected to one side only of a frame, characterised in that the ratio W₂/L₂ of the width W₂ to the length L₂ of the flexural portion does not exceed the value which satisfies the relationship:

$\text{U₁ > U₂}$

wherein, 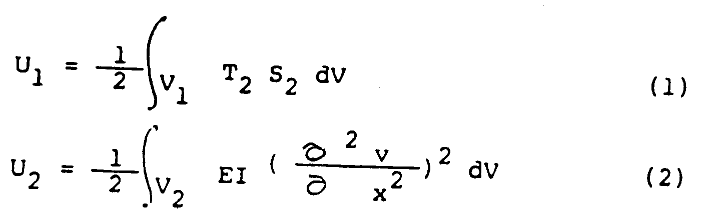
and in which T₂ is stress; S₂ is distortion; E is Young's modulus; I is the moment of inertia; v is displacement; V₁, V₂ are volumes and x is a coordinate.

This construction enables the resonator to have very little vibrational leakage, i.e. losses caused by the vibration. Moreover, the resonator may have a small series resistance and a high Q-value.

Preferably, the said one side of the frame is disposed opposite a further side of the frame, the said futher side being adapted to be secured to fixed structure so as to act as a mounting portion of the resonator.

Preferably, the flexural portion surrounds the vibrational portion and is connected to the latter by bridge portions which are disposed on opposite sides of the vibrational portion, the frame surrounding the flexural portion.

The resonator preferably has an intermediate frequency of approximately 1 MHz.

The resonator is preferably a one-piece quartz crystal resonator which has been made by an etching method.

The invention is illustrated, merely by way of example, in the accompanying drawings, in which:-
Figures 1(A) and (B) are a schematic plan and a schematic side view respectively of a vibrator, Figures 1(A) and 1(B) being provided to illustrate the basic theory of the present invention; and
Figure 2 is a plan view illustrating one embodiment of a resonator according to the present invention.

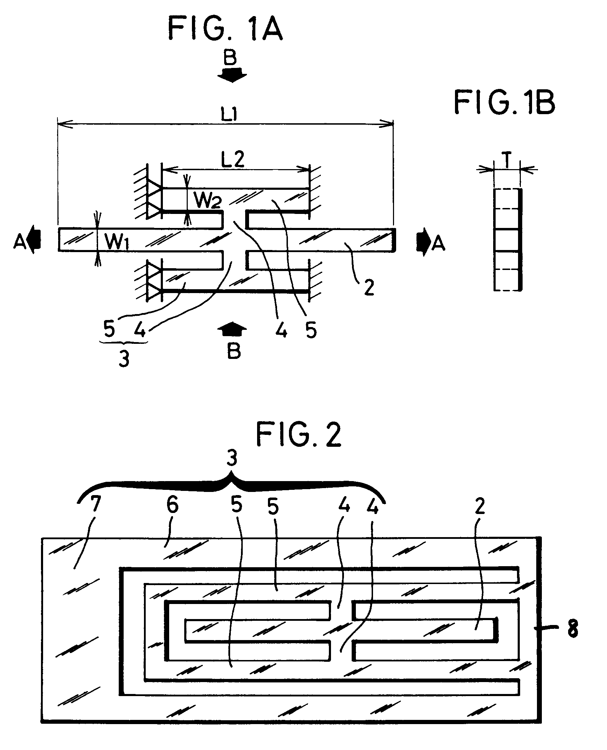

In Figures 1(A) and 1(B) there is shown a resonator which consists of a vibrational portion 2 and a supporting portion 3. The supporting portion 3 is composed of two bridge portions 4 and two flexural portions 5. It will be noted that the left hand end of each of the flexural portions 5 is clamped, while the right hand end thereof is supported. Consequently, both the displacement and the rotational moment are zero at the clamped ends of the flexural portions. On the other hand, the displacement is zero but the rotational moment is not zero at the other ends of the flexural portions which are supported.

The vibrational portion 2 has a length L₁, a width W₁ and a thickness T, while each of the flexural portions 5 has a length L₂ and a width W₂. When the vibrational portion 2 of the resonator now undergoes, as indicated by arrows A, extensional displacement, it will be appreciated that,as indicated by arrows B, there will be inward movement in a flexural mode at the flexural portions 5. On the other hand, when the vibrational portion 2 is compressed, there will be outward movement in the flexural mode at the flexural portions 5. Thus the displacement in the width direction of the vibrational portion 2 is converted into oscillation in the flexural mode of the flexural portion 5, whereby the degree of freedom of the vibration is not restrained.

Furthermore, the dimensions of the parts are selected so that the vibration is not restrained. The dimensions are determined by the strain energy of the vibrational portion 2. If the strain energy of the vibrational portion 2 is U₁, and the strain energy of the flexural portions is U₂, then U₁ and U₂ are expressed by the following equations:- 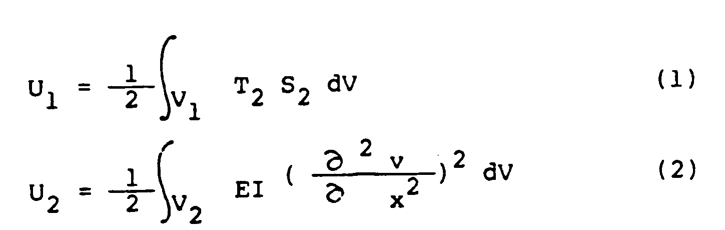
where T₂ is stress, S₂ is distortion, E is Young's modulus, I is the moment of inertia, v is displacement, V₁ and V₂ are volumes, and x is a coordinate. In order not to suppress the vibration of the longitudinal quartz crystal resonator, the following relation must be satisfied:-

$\text{U₁ > U₂ (3)}$

From the equations (1), (2) and (3), the dimensions L₂ and W₂ of the flexural portion 5 are determined. For instance, when the frequency is 1 MHz, and when the vibrational portion z has a length L₁ = 2.6mm, a width W₁ = 80 µm and a thickness T = 160 µm, the dimensional ratio W₂/L₂ of the flexural portion 5 is 0.16 or less. As a result, a longitudinal quartz crystal resonator having a low series resistance and a high Q-value is obtained.

Reference will now be made to the vibrational leakage. As is obvious from the schematic diagram of Figures 1(A) and 1(B), the vibrational energy of the vibrational portion 2 is transmitted via the bridge portions 4 to the flexural portions 5. Accordingly, it is desirable to minimize the loss of energy at the flexural portions 5. If the mass of the clamped ends of the flexural portions 5 is infinitely large, it follows that the energy of the flexural portions 5 will not leak out. Similarly, it is possible to eliminate the energy leakage by arranging that the supported ends of the flexural portions 5 are free from a mounting portion of the resonator while their other ends are clamped. Accordingly the vibration of the vibrational portion 2 is made free by selecting a particular dimension of the flexural portions 5 i.e., the dimensional ratio W₂/L₂ of the width W₂ to the length L₂. Moreover, the two clamped portions of the flexural portions 5 are connected to a frame and the mass of the latter is augmented.

Referring to Figure 2, there is illustrated one embodiment of a longitudinal quartz crystal resonator according to the present invention. The resonator comprises a vibrational portion 2 and a supporting portion 3 which are formed in one united body by an etching method. The supporting portion 3 comprises a flexural portion 5 which surrounds the vibrational portion 2 and is connected to the latter by two bridge portions 4 which are disposed on opposite sides of the vibrational portion 2, the flexural portion 5 being directly connected to one side 8 only of a frame 6 which surrounds the flexural portion 5. The flexural portion 5 thus supports the vibrational portion 2 by way of the bridge portions 4.

There will now be described how restraint of the longitudinal vibration of the vibrational portion 2 is prevented. The vibrational portion 2 is extended and compressed in the longitudinal direction as a result of an externally applied electric field (not shown). Simultaneously, the vibrational portion 2 vibrates likewise in the perpendicular direction, viz., in the direction of the bridge portions 4. At this time, it is of importance that the vibrational portion 2 should vibrate in the direction of the bridge portions 4 sufficiently freely in order to permit the vibration of the vibrational portion 2 in the longitudinal direction to be freely excited. It is possible to prevent suppression of the longitudinal vibration of the vibrational portion 2 by arranging for a suitable ratio of the width W₂ to the length L₂ of the flexural portion 5 of the supporting portion 3, e.g. by arranging that W₂/L₂ is 0.16 or less and the frequency is 1 MHz.

Reference will now be made to the way in which a longitudinal quartz crystal resonator having substantially no vibrational leakage is obtained. The flexural portion 5 is connected to the vibrational portion 2 via the bridge portions 4. The flexural portion 5, the vibrational portion 2 and the bridge portions 4 are integrally formed by the etching method, while the two right hand ends of the flexural portion 5 are connected to the frame 6. In this case, the flexural portion 5 vibrates in a flexural mode. The flexural portion 5 is arranged such that the two right hand ends thereof are connected to the frame 6, while the left hand end of the flexural portion 5 encircles the vibrational portion 2 to vibrate freely. Hence, the flexural portion 5 vibrates while one end thereof is clamped and the other end thereof is supported. If the mass of the frame 6 is considerably increased, the energy is trapped in the left hand end of the flexural portion 5. As a result, a longitudinal quartz crystal resonator which has very little vibrational leakage is obtained, even if the resonator is mounted at a mounting portion 7 of the frame 6 which is disposed opposite to the side 8 thereof, the mounting portion 7 being adapted to be secured to fixed structure (not shown).

A longitudinal quartz crystal resonator as shown in Figure 2 having a vibrational portion 2 and a supporting portion 3 formed by the etching method has the following outstanding advantages:
(1) The series resistance of the resonator decreases because of its improved shape, and the dimensions of the supporting portion 3 are such as to give free vibration;
(2) The flexural portion 5 is directly connected to the frame 6 only at the side 8 of which is opposite to the mounting portion 7,and the frame 6 therefore has the same effect as would be obtained by increasing the mass thereof, resulting in a minimized amount of leakage of vibration;
   and
(3) It is easy to manufacture resonators of the kind shown in Figure 2 and possible to miniaturize them because of the one-sided mounting.

## Claims

1. A one-piece longitudinal piezo-electric resonator comprising a vibrational portion (2) and a flexural portion (5) which supports the vibrational portion (2) by way of bridge means (4) and which is directly connected to one side (8) only of a frame (6), characterised in that the ratio W₂/L₂ of the width W₂ to the length L₂ of the flexural portion (5) does not exceed a value which satisfies the relationship:
$\text{U₁ > U₂}$
wherein, 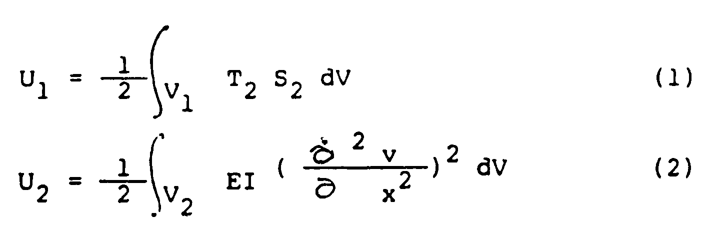 and in which T₂ is stress; S₂ is distortion; E is Young's modulus; I is the moment of inertia; v is displacement; V₁ and V₂ are volumes and x is a coordinate.

2. A resonator as claimed in claim 1 characterised in that the said one side (8) of the frame (6) is disposed opposite a further side (7) of the frame (6), the said further side (7) being adapted to be secured to fixed structure so as to act as a mounting portion of the resonator.

3. A resonator as claimed in claim 1 or 2 in which the flexural portion (5) surrounds the vibrational portion (2) and is connected to the latter by bridge portions (4) which are disposed on opposite sides of the vibrational portion (2), the frame (6) surrounding the flexural portion (5).

4. A resonator as claimed in any preceding claim characterised in that the resonator has an intermediate frequency of approximately 1 MHz.

5. A resonator as claimed in any preceding claim characterised in that the resonator is a one-piece quartz crystal resonator which has been made by an etching method.

## Patentansprüche

1. Einstückiger, longitudinaler piezoelektrischer Resonator, umfassend einen Schwingungsabschnitt (2) und einen Biegungsabschnitt (5), welcher den schwingungsabschnitt (2) mit Hilfe von Brückenmitteln (4) trägt und nur mit einer Seite (8) eines Rahmens (6) direkt verbunden ist,
**dadurch gekennzeichnet**, daß
das Verhältnis W₂/L₂ der Breite W₂ zu der Länge L₂ des Biegungsabschnitts (5) einen Wert nicht überschreitet, welcher die Beziehung:
$\text{U₁ > U₂}$
mit 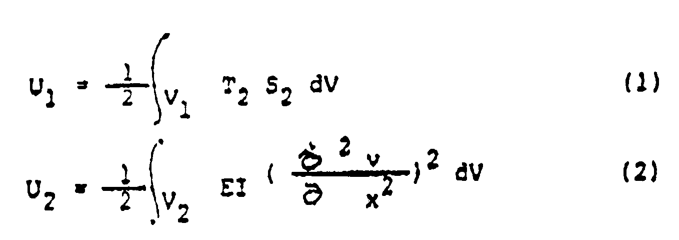 erfüllt, wobei T₂ die Spannung, S₂ die Verformung, E der Elastizitätsmodul, I das Trägheitsmoment, v die Verschiebung, V₁ und V₂ Volumina und x eine Koordinate ist.

2. Resonator nach Anspruch 1, dadurch gekennzeichnet, daß die eine Seite (8) des Rahmens (6) entgegengesetzt zu einer weiteren Seite (7) des Rahmens (6) angeordnet ist, wobei die weitere Seite (7) dazu ausgelegt ist, an einer festen Struktur befestigt zu werden, so daß sie als ein Halterungsabschnitt des Resonators wirkt.

3. Resonator nach Anspruch 1 oder 2, bei welchem der Biegungsabschnitt (5) den Schwingungsabschnitt (2) umgibt und mit dem letzteren durch Brückenabschnitte (4) verbunden ist, welche an entgegengesetzten Seiten des Schwingungsabschnitts (2) angeordnet sind, wobei der Rahmen (6) den Biegungsabschnitt (5) umgibt.

4. Resonator nach einem der vorhergehenden Ansprüche,
dadurch gekennzeichnet, daß
der Resonator eine Mittenfrequenz von ungefähr 1 MHz aufweist.

5. Resonator nach einem der vorhergehenden Ansprüche,
dadurch gekennzeichnet, daß
der Resonator ein einstückiger, durch ein Ätzverfahren hergestellter Quarzkristallresonator ist.

## Revendications

1. Résonateur piézo-électrique longitudinal en une seule pièce comprenant uns partie de vibration (2) et une partie de flexion (5) qui supporte la partie de vibration (2) par des moyens de pontage (4) et qui est reliée directement à un côté (8) seulement d'un cadre (6), caractérisé en ce que le rapport W₂/L₂ de la largeur W₂ à la longueur L₂ de la partie de flexion (5) ne dépasse pas une valeur qui satisfait à la relation :
$\text{U₁ > U₂}$
dans laquelle 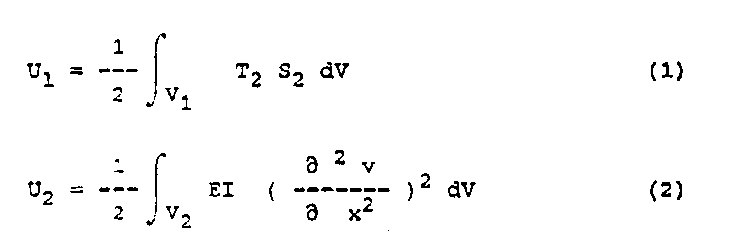 et dans laquelle T₂ est la contrainte, S₂ la distorsion, E la module d'Young, I le moment d'inertie, V le déplacement, V₁ et V₂ des volumes et X une coordonnée.

2. Résonateur suivant la revendication 1, caractérisé en ce que ledit côté (8) du cadre (6) est disposé à l'opposé d'un autre côté (7) du cadre (6), l'autre côté (7) étant agencé pour être fixé à une structure fixe de manière à servir de partie de montage du résonateur.

3. Résonateur suivant la revendication 1 ou 2 dans lequel la partie de flexion (5) entoure la partie de vibration (2) et relié à cette dernière par des parties de pontage (4) qui sont disposées sur des côtés opposés de la partie de vibration (2), le cadre (6) entourant la partie de flexion (5).

4. Résonateur suivant l'une quelconque des revendications précédentes, caractérisé en ce que le résonateur a une fréquence intermédiaire d'environ 1 MHz.

5. Résonateur suivant l'une quelconque des revendications précédentes, caractérisé en ce que le résonateur est un résonateur en cristal de quartz en une seule pièce, qui a été fabriqué par un procédé de gravure.
